# EUROPÄISCHE PATENTSCHRIFT

(11) **EP 1 360 510 B1**
(45) Veröffentlichungstag und Bekanntmachung des Hinweises auf die Patenterteilung: **06.04.2005**
(21) Anmeldenummer: 02700167.6
(22) Anmeldetag: 25.01.2002
(51) Int. Cl.: G01R 15/20

(54) **HALBLEITERANORDNUNG ZUR STROMMESSUNG**
SEMICONDUCTOR ASSEMBLY FOR MEASURING CURRENT INTENSITY
ENSEMBLE A SEMICONDUCTEURS SERVANT A MESURER UN COURANT

(30) Priorität: 06.02.2001 DE 10105186
(43) Veröffentlichungstag der Anmeldung: 12.11.2003
(73) Patentinhaber: ROBERT BOSCH GMBH, 70442 Stuttgart (DE)
(72) Erfinder: ERNST, Stephan, 73760 Ostfildern (DE); FEILER, Wolfgang, 72766 Reutlingen (DE); QU, Ning, 72770 Reutlingen (DE)
(86) Internationale Anmeldenummer: PCT/DE2002/000244
(87) Internationale Veröffentlichungsnummer: WO 2002/063316

(56) Entgegenhaltungen:
- EP-A- 0 286 079
- US-A- 4 262 275
- US-A- 5 570 034
- ALLEGRETTO W ET AL: "NUMERICAL ANALYSIS OF MAGNETIC-FIELD-SENSITIVE BIPOLAR DEVICES" IEEE TRANSACTIONS ON COMPUTER AIDED DESIGN OF INTEGRATED CIRCUITS AND SYSTEMS, IEEE INC. NEW YORK, US, Bd. 10, Nr. 4, 1. April 1991 (1991-04-01), Seiten 501-511, XP000219195 ISSN: 0278-0070 in der Anmeldung erwähnt

## Beschreibung

### Stand der Technik

Zur Messung der elektrischen Stromstärke an vielen Stellen, insbesondere im Kraftfahrzeug, werden bisher sogenannte Shunt-Widerstände eingesetzt, wobei solche Shunt-Widerstände als in dem zu messenden Stromzweig eingebrachte Ohmsche Widerstände ausgebildet sind. Nachteilig hierbei ist, dass keine Potentialtrennung zwischen Meßkreis und Nutzkreis besteht.

Solche Nachteile werden teilweise vermieden, wenn nicht die Stromstärke direkt gemessen wird, sondern ihre Magnetfeldwirkung um den stromführenden Leiter herum. Dies kann mit Hall-Elementen geschehen oder auch mit sogenannten LMT-Elementen (lateraler Magneto-Transistor).

Zur Bestimmung des Stromes in einem Leiter beliebigen Querschnittes ist die Messung des Magnetfeldes an einem Ort im allgemeinen jedoch nicht ausreichend. Gemäss den Maxwellschen Gleichungen existiert nämlich keine für alle denkbaren Anordnungen gültige Verknüpfung zwischen dem Stromfluß im Leiter und dem Magnetfeld in seiner Umgebung. Erst das den stromdurchflossenen Leiter umschließende Umlaufintegral über die magnetische Feldstärke liefert unter Vernachlässigung des Verschiebungsstromes eindeutig für alle Anordnungen den Strom im Leiter.

Um diesem Umstand Rechnung zu tragen, setzt man hochpermeable Magnetfeldkonzentratoren ein, in deren Luftspalt ein Hall-Element plaziert ist und die mit diesen eine den Strom führenden Leiter vollständig umschließende Schleife bilden. Nachteilig an einer solchen Anordnung ist das notwendige Bauvolumen für den Magnetfeldkonzentrator, die aufwendige Aufbau- und Verbindungstechnik und gegebenenfalls ihr Gewicht. Außerdem kann der hochpermeable Magnetfeldkonzentrator bei grösseren Magnetfeldern Nichtlinearitäten bzw. Hystereseeffekte zeigen, die für hochgenaue Messungen nicht tolerierbar sind und mittels. aufwendiger Kompensationsverfahren korrigiert werden müssen.

EP-A-0 286 079 offenbart eine Halbleiteranordnung zur Strommessung mit einer Ausnehmung, in der ein elektrischer Leiter vorgesehen ist. Die Sensormittel setzen sich aus einer Vielzahl von Einzelelementen Zusammen.

### Vorteile der Erfindung

Die erfindungsgemäße Halbleiteranordnung gemäß den Anspruch 1, der Strommesser und das Kraftfahrzeug mit den Merkmalen der nebengeordneten Patentansprüche haben demgegenüber den Vorteil, dass die Bestimmung des elektrischen Stromflusses in einem Stromleiter mit beliebigem Querschnitt durch Messung des ihn umgebenden Magnetfeldes ermöglicht wird, wobei ein geringes Bauvolumen, ein geringes Gewicht und die Abwesenheit von Sättigungseffekten, insbesondere durch Nichtlinearitäten oder Hystereseeffekte, erreicht werden.

Vorteilhaft ist insbesondere, dass das Sensormittel selbst ein dem Umlaufintegral der magnetischen Feldstärke und damit dem von ihm durchflossenen Strom proportionales Signal ohne Magnetfeldkonzentrator liefert.

Durch die in den Unteransprüchen aufgeführten Maßnahmen sind vorteilhafte Weiterbildungen und Verbesserungen der in den nebengeordneten Ansprüchen angegebenen Halbleiteranordnung des Strommessers und des Kraftfahrzeugs möglich.

### Zeichnung

Ausführungsbeispiele der Erfindung sind in der Zeichnung dargestellt und in der nachfolgenden Beschreibung näher erläutert. Es zeige
Figur 1 eine einfache Ausführungsform eines Hall-Elementes,
Figur 2 einen Stromsensor unter Verwendung eines Hall-Elementes,
Figur 3 eine Draufsicht auf eine erste Ausführungsform der erfindungsgemäßen Halbleiteranordnung,
Figur 4. einen Querschnitt durch die erste Ausführungsform der erfindungsgemäßen Halbleiteranordnung,
Figur 5 ein Applikationsbeispiel für die erste Ausführungsform der erfindungsgemäßen Halbleiteranordnung,
Figur 6 eine Draufsicht auf eine zweite Ausführungsform der erfindungsgemäßen Halbleiteranordnung,
Figur 7 einen Querschnitt durch die zweite Ausführungsform der erfindungsgemäßen Halbleiteranordnung,
Figur 8 ein Applikationsbeispiel für die zweite Ausführungsform der erfindungsgemäßen Halbleiteranordnung.

### Beschreibung der Ausführungsbeispiele

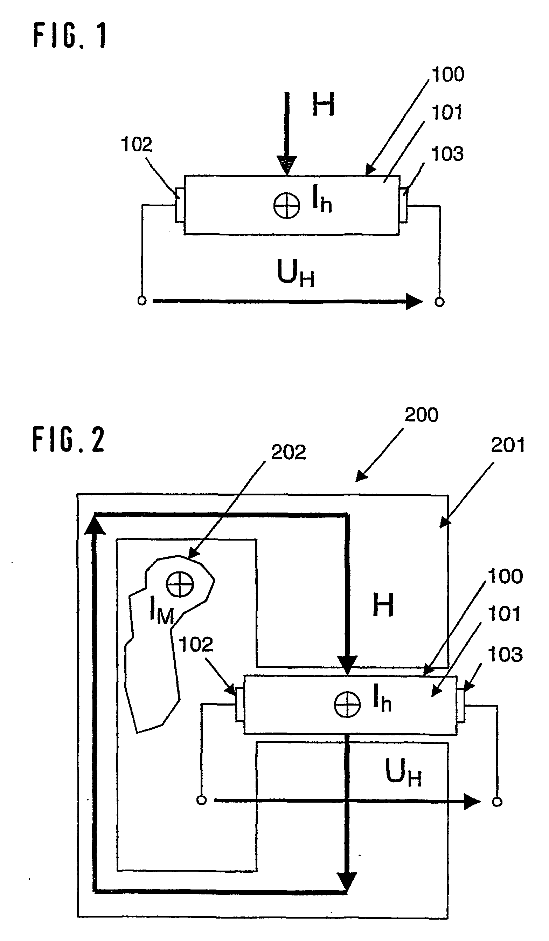

In Figur 1 ist ein Hall-Element 100 dargestellt. Das Hall-Element 100 besteht.im wesentlichen aus einem Halbleiterplättchen 101, das von einem die Zeichenebene senkrecht durchsetzenden Strom Iₕ durchflossen wird. Das Halbleiterplättchen umfasst an beiden Seiten jeweils eine Elektrode, nämlich eine erste Meßelektrode 102 und eine zweite Meßelektrode 103. Bei Anwesenheit einer senkrecht zum Strom Iₕ weisenden Komponente eines Magnetfeldes H bewirkt die Lorenzkraft eine Ablenkung der den Strom tragenden Ladungen in die Richtung, die auf der von dem Strom Iₕ und der wirksamen Magnetfeldkomponente H aufgespannten Ebene senkrecht steht. Dies führt dazu, dass zwischen den Elektroden 102, 103 eine dem Magnetfeld H, bzw. eine der Komponente des Magnetfeldes H, die senkrecht auf dem Strom Iₕ steht, proportionale, sogenannte Hall-Spannung U_{H} messbar ist. Damit ist die Messung der Magnetfeldkomponente H am Ort des Hall-Elementes möglich.

Zur Messung der Stromstärke eines stromdurchflossenen Leiters über die Messung des den stromdurchflossenen Leiter umgebenen Magnetfeldes führt jedoch im allgemeinen erst das den stromdurchflossenen Leiter umschließende Umlauf-Integral über die magnetische Feldstärke (unter Vernachlässigung des Verschiebungsstromes) zu einer korrekten Messung der Stromstärke im stromdurchflossenen Leiter. In Figur 2 ist eine Anordnung 200 zur Messung der Stromstärke eines stromdurchflossenen Leiters unter'Verwendung des Hallelementes 100 dargestellt, wobei die Anordnung 200 einen hochpermeablen Magnetfeldkonzentrator.201 aufweist, der den magnetischen Fluß um den im stromführenden Leiter 202 fließenden Strom konzentriert und in einen Luftspalt weiterleitet, in dem sich das Hallelement 100 befindet. Hierbei ist wiederum das Halbleiterplättchen 101, die beiden Meßelektroden 102, 103 des Hallsensors 100 und der für die Hallspannung U_{H} notwendige senkrecht zum Magnetfeld H fließende Strom Iₕ erkennbar.

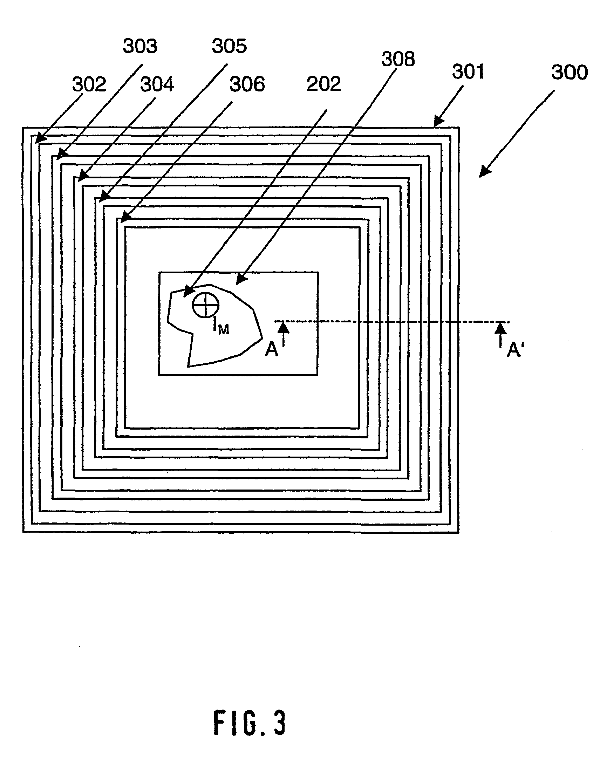

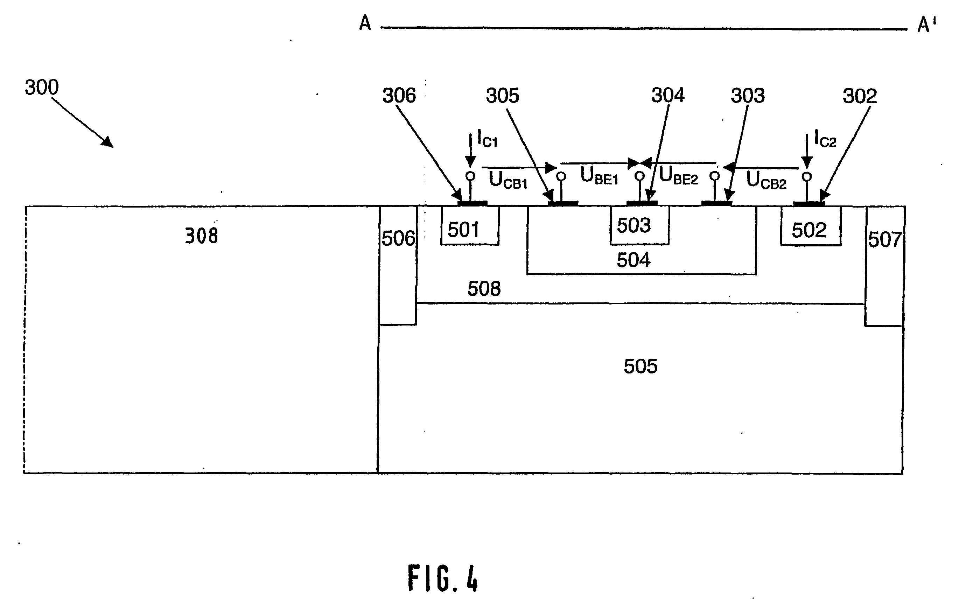

In Figur 3 ist eine Draufsicht auf eine erste Ausführungsform der der erfindungsgemäßen Halbleiteranordnung dargestellt. In Figur 3 bezeichnet das Bezugszeichen 301 einen Halbleiterchip, in dem ein erfindungsgemäßer lateraler Magneto-Transistor 300 realisiert ist, der erfindungsgemäß ringförmig in der folgendermaßen beschriebenen Aufbauart vorgesehen ist und daher als Ring-LMT 300 bezeichnet wird. Der erfindungsgemäße Ring-LMT 300 bzw. der Halbleiterchip 301, in dem er realisiert ist, weist ein Loch 308 auf, das der Ring-LMT 300 in einer beliebigen, überkreuzungsfreien Kontur vollständig umschließt. Die Kontur kann dabei beispielsweise quadratisch, rund, rechteckig, sechseckig oder dergleichen vorgesehen sein. Durch das Loch 308 führt der den Strom I_{M} führende Leiter 202. Eine halbseitige Querschnittslinie durch den Ring-LMT 300 ist in Figur 3 durch die Buchstaben A-A' bezeichnet und verläuft vom inneren Rand des Ring-LMT 300, d.h. der Rand, der an das Loch 308 angrenzt, bis zum äußeren Rand des Ring-LMT 300. Ein Querschnitt durch die erste Ausführungsförm des erfindungsgemäßen Ring-LMT 300' entlang der Schnittlinie A-A' ist in Figur 4 dargestellt.

In Figur 4 ist die Schnittlinie A-A' noch einmal eingezeichnet. Ansonsten ist in Figur 4 die eine Seite des Ring-LMT 300 dargestellt, wobei wiederum das Loch 308 auf der einen Seite, nämlich am Buchstaben A der Schnittlinie A-A' und der äußere Rand des Ring-LMT 300 beim Buchstaben A' erkennbar ist. Der Querschnitt durch die eine Seite des Ring-LMT 300 unterscheidet sich nicht von einem herkömmlichen lateralen Magneto-Transistor.

Der grundlegende Aufbau eines LMT entspricht dem in W.Allegreto et al., IEEE Trans.-CAD, Vol.10, No.4, 1991, Seiten 501-511 vorgeschlagenen Querschnitt eines ebenen LMT. Prinzipiell sind aber auch abgewandelte LMT denkbar.

Wie bei lateralen Magneto-Transistoren üblich, ist eine Emittermetallisierung 304 in der Mitte vorgesehen, unterhalb der sich ein im Beispiel n-dotiertes Emittergebiet 503 befindet. Das Emittergebiet 503 ist in ein im Beispiel p-dotiertes Basisgebiet 504 eingebettet, auf dem sich symmetrisch zur Emittermetallisierung 304 die lateralen Basismetallisierungen 303 und 305 befinden. Das im Beispiel p-dotierte Basisgebiet 504 ist seinerseits in eine im Beispiel n-dotierte Schicht 508 eingebettet, die in ein im Beispiel p-dotiertes Substrat 505 eingebracht ist. In die n-dotierte Schicht 508 sind symmetrisch zum Emittergebiet 503 und abgetrennt vom Basisgebiet 504 die lateralen Kollektorgebiete 501 und 502 im Beispiel als n-dotierte Gebiete eingebettet. Oberhalb der Kollektorgebiete 501, 502 befinden sich jeweils ein Kollektoranschluß 302, 306, die als Metallisierungen ausgebildet sind. Symmetrisch um das Emittergebiet 503 und seitlich außerhalb der Kollektorgebiete 501, 502 wird die im Beispiel n-dotierte Schicht 508 von jeweils einer im Beispiel p-dotierten Isolationsstruktur 506, 507 begrenzt. Erfindungsgemäß ist insbesondere vorgesehen, dass der Querschnitt einer Seite eines solchen Ring-LMT 300 bzgl. einer.senkrecht durch den Emitterbereich 503 verlaufenden gedachten Linie symmetrisch ist. Die "innere" Seite, d.h., die Seite, die zu dem Loch 308 weist, wird im folgenden auch als die erste Seite, umfassend die erste Basis 305 und den ersten Kollektor 306, bezeichnet und die äußere Seite wird als die zweite Seite, umfassend die zweite Basis 303 und den zweiten Kollektor 302, bezeichnet. Im Betrieb werden gleiche Kollektorbasisspännungen zwischen dem ersten Kollektor 306 und der ersten Basis metallisierung 305 (erste Kollektorbasisspannung) und der zweiten Basis metallisierung 303 und dem zweiten Kollektor 302 (zweite Kollektorbasisspannung) angelegt. Weiterhin sind auch die Basisemitterspannungen, nämlich die Spannung zwischen der ersten Basis metallisierung 305 und dem Emitter 304 (erste Basisemitterspannung) und die Spannung zwischen der zweiten Basis metallisierung 303 und dem Emitter 304 (zweite Basisemitterspannung) gleich. Durch den symmetrischen Aufbau stellen sich ohne angelegtes Magnetfeld gleiche Kollektorströme zwischen dem ersten Kollektor 306 und dem Emitter 304 (erster Kollektorstrom) und zwischen dem zweiten Kollektor 302 und dem Emitter 304 (zweiter Kollektorstrom) ein. Es gilt also für den Fall ohne Magnetfeld, dass die Differenz des ersten Kollektorstroms zum zweiten Kollektorstroms verschwindet. Die Kollektorströme fliessen über die Metallisierungen 302, 306 der Kollektorgebiete 501, 502, die auch als Kollektordiffusionen 501, 502 bezeichnet werden, in das im Beispiel n-dotierte Gebiet 508, treten im wesentlichen unterhalb des Emitterbereichs 503 in das Basisgebiet 504 ein und fließen zuzüglich der kleinen, über die Basismetallisierungen 303, 305 in den Basisbereich 504 eintretenden Basisströme vertikal in den Emitterbereich 503 ein und fließen über die Emittermetallisierung 304 ab. Wird nun ein Magnetfeld senkrecht zur Zeichenebene angelegt, so werden die vertikal von dem Gebiet 508 über das Basisgebiet 504 zum Emittergebiet 503 fließenden Ströme derart durch die Lorenzkraft abgelenkt, dass die Differenz der Kollektorströme nicht mehr verschwindet, d.h., von Null verschieben wird. Die Differenz der Kollektorströme ist dabei proportional zu der senkrecht zur Zeichenebene den LMT durchsetzenden Magnetfeldkomponente.

Umschließt man demnach erfindungsgemäß einen stromführenden Leiter 202 vollständig durch einen Ring-LMT 300, werden gewissermaßen die Kollektorströme aller senkrecht zum umfahrenen Weg auftretenden Querschnitte integriert, so dass die Differenz der solchermaßen gewonnen Kollektorströme dem Umlaufintegral des Magnetfeldes um den in dem Loch 308 sich befindenden Leiter 202 entspricht und daher zur Strommessung verwendet werden kann. Das Signal des Ring-LMT 300, nämlich die Differenz der Kollektorströme, ist proportional zu einem solchen Umlaufintegral des Magnetfeldes um den stromführenden Leiter.

Durch die zur Figur 4 vorgenommene Beschreibung werden auch die im Zusammenhang mit Figur 3 noch nicht definierten Bezugszeichen näher bestimmt. Das Bezugszeichen 302 bezeichnet die in Figur 3 ringförmig sichtbare Metallisierung des zweiten Kollektorgebietes 502, wobei das zweite Kollektorgebiet 502 in Figur 3 nicht dargestellt ist. Das Bezugszeichen 303 bezeichnet die in Figur 3 ringförmig angeordnete Metallisierung der zweiten Basis des Ring-LMT 300. Das Bezugszeichen 304 bezeichnet die ringförmig angeordnete Metallisierung oberhalb des Emittergebietes. 503, das in Figur 3 nicht dargestellt ist. Das Bezugszeichen 305 bezeichnet die ringförmig angeordnete Metallisierung der ersten Basis und das Bezugszeichen 306 bezeichnet die ringförmig angeordnete Metallisierung des zweiten Kollektorgebietes 501, wobei das zweite Kollektorgebiet 501 in Figur 3 nicht dargestellt ist. Wie oben bereits gesagt, ist die Form der Konturen der Metallisierungen 302-306 erfindungsgemäß beispielsweise viereckig, vieleckig, oval oder kreisförmig vorgesehen. Bei der Wahl der Kontur sollte aus Gründen eines möglichst geringen Offsets zwischen dem ersten Kollektorgebiet 501 und dem zweiten Kollektorgebiet 502 und zwischen dem inneren Teilbasisgebiet des Basisgebiets 504, das dem ersten Basisanschluß 305 entspricht, und dem äußeren Teilbasisgebiet des Basisgebiets 504, das dem zweiten Basisanschluß 303 entspricht, die Umlauflängen der beiden Kollektorgebiete, bzw. des Basisgebiets 504, des Ring-LMT 300, möglichst gleich sein. Im in Figur 3 gezeigten Beispiel fließt der zu messende Strom I_{M} in die Zeichenebene hinein und erzeugt ein ihn umschließendes und in der Zeichenebene liegendes Magnetfeld, wobei das Magnetfeld nicht dargestellt ist.

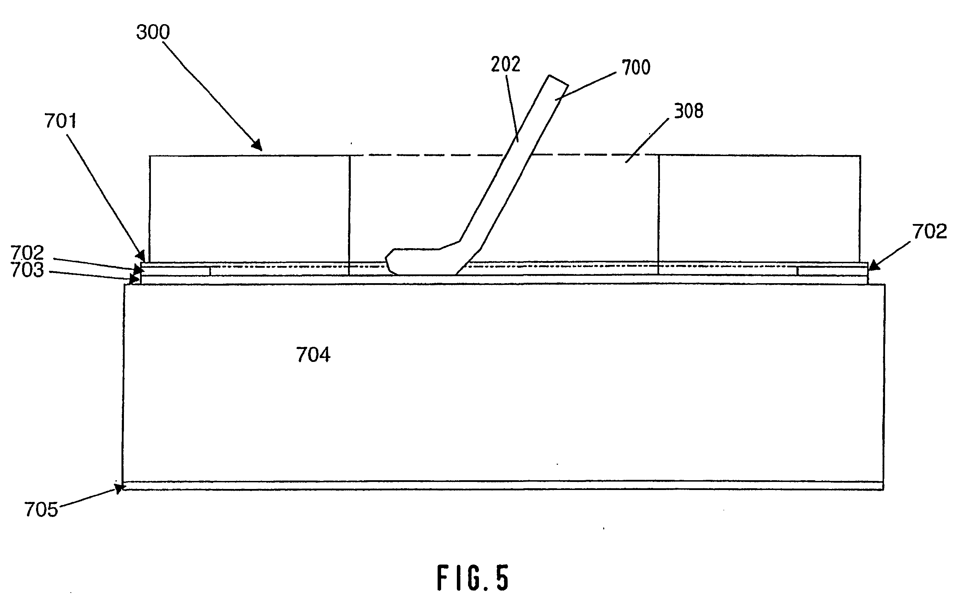

Figur 5 zeigt ein Applikationsbeispiel für den Ring-LMT 300 gemäss der ersten Ausführungsform. Der Ring-LMT 300 wird . hierzu mittels einer Kleberschicht 701 Sourceseitig auf einem PowerMOS fixiert. Der stark schematisch dargestellte PowerMOS umfasst dabei einen Halbleiter 704, eine Drainmetallisierung 705, eine Sourcemetallisierung 703 und eine üblicherweise vorhandene Nitridpassivierung 702. Die Nitridpassivierung 702 verläuft ebenfalls ringförmig und bildet ein Fenster, das die Sourcemetallisierung 703 nach oben hin zumindest teilweise freigibt. Auf dem PowerMOS befindet sich der erfindungsgemäße Ring-LMT 300, der oberhalb des Fensters in der Nitritpassivierung 702, das in Figur 3 und 4 bereits dargestellte Loch 308 umfasst. Durch das Fenster in der Nitridpassivierung 702 und das Loch 308 im Ring-LMT 300 führt ein Sourcebond 700, der die Sourcemetallisierung 703 kontaktiert, der als der stromführende Leiter 202 gemäss der Figur 3 aufzufassen ist, der den zu messenden strom I_{M} trägt. Diese durch den Sourcebond 700 fliessende und zu messende Strom I_{M} wird im Applikationsbeispiel vom PowerMOS gesteuert.

Alternativ ist ebenso erfindungsgemäß vorstellbar, dass der Ring-LMT 300 prinzipiell auch Drainseitig am PowerMOS angebracht werden kann. Statt eines PowerMOS kann der Ring-LMT 300 auch auf einer.metallisierten Leiterplatte (nicht dargestellt) oder Keramik (ebenfalls nicht dargestellt) angebracht werden. In diesem Fall würde das Bezugszeichen 704 als die isolierende Leiterplatte bzw. Keramik angesehen werden und die Bezugszeichen 703 bzw. 705 als die als Leiterbahnen ausgeführten Ober- bzw. Unterseitenmetallisierungen der Leiterplatte bzw. Keramik angesehen werden. Das Bezugszeichen 702 würde dann als eine isolierende Schicht angesehen werden, durch deren Öffnungen der den Strom führenden Bond auch die Leiterbahn geführt ist und das Bezugszeichen 701 würde als eine ringförmige Kleberschicht ausgeführt werden.

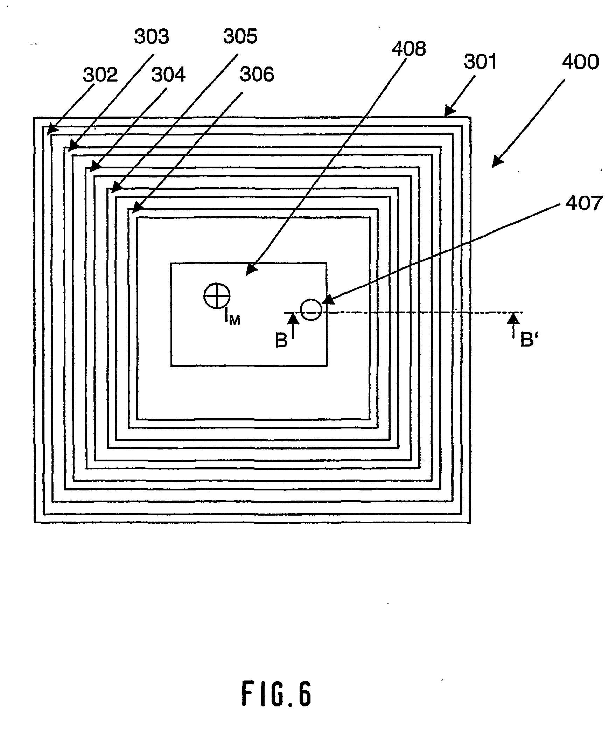

In Figur 6 ist eine Draufsicht auf eine zweite Ausführungsform des erfindergemäßen Ring-LMT, wobei die zweite Ausführungsform des erfindergemäßen Ring-LMT mit dem Bezugszeichen 400 versehen wird. Gleiche Bezugszeichen aus der Figur 3 entsprechen gleichen Teilen des Ring-LMT 400. In Figur 6 ist eine zweite Querschnittlinie B-B' durch eine Seite des wiederum ringförmig angeordneten Ring-LMT 400 eingezeichnet. Im Gegensatz zur ersten Ausführungsform des Ring-LMT 300 beinhaltet die zweite Ausführungsform des Ring-LMT 400 bereits ein Leitungsstück, das den Strom I_{M} durch den Ring-LMT 400 führt. Dies kann vorteilhaft für die Aufbau- und Verbindungstechnik genutzt werden. Das Leitungsstück besteht aus einer z.B. gesputterten Metallschicht 408, die über mindestens 1 Kontaktierungsloch 407 die Chip-Vorder- und Chip-Rückseite des Ring-LMT 400 niederohmig miteinander verbindet. Zur elektrischen Isolation des Ring-LMT 400 vom.Leitungsstück 407 wird ein z.B. thermisch erzeugtes Dielektrikum 601 verwendet; das in Figur 6 noch nicht dargestellt ist. Wesentlich ist, dass auch bei dieser zweiten Ausführungsform des Ring-LMT 400, das den zu messenden Strom I_{M} führende Leitungsstück von dem Ring-LMT 400 auf einer vollständig geschlossenen, kreuzungsfreien Kontur umschlossen ist. Neben der gezeigten viereckigen Kontur sind wiederum auch vieleckige, ovale oder kreisförmige Konturen möglich. Bei der Wahl der Kontur sollten wiederum aus Gründen eines möglichst geringen Offsets die Umlauflängen der beiden Kollektorgebiete 501, 502 des Ring-LMT 400 möglichst gleich sein. Die Kollektorgebiete 501, 502 sind wiederum in Figur 6 nicht dargestellt, entsprechen jedoch denen in Figur 4 dargestellten Gebieten.

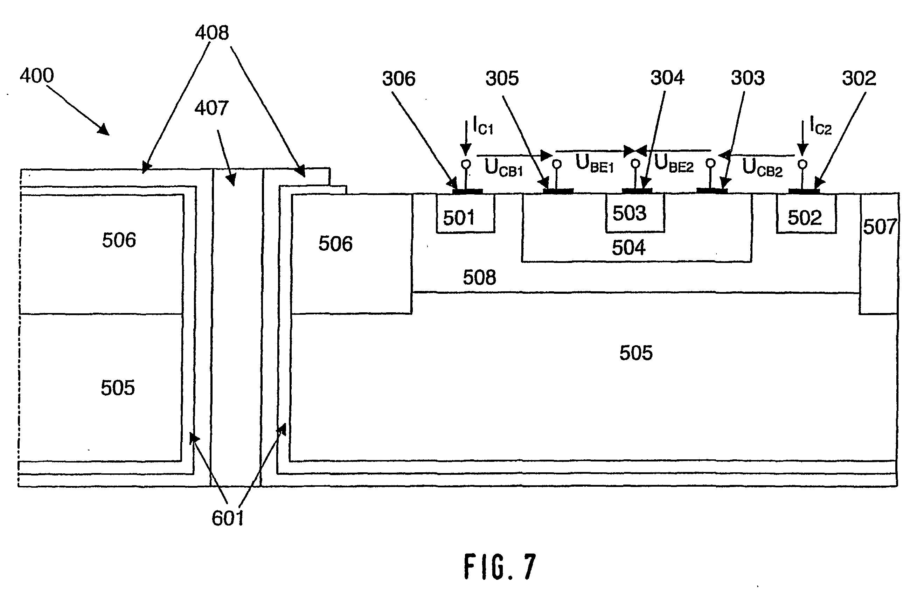

In Figur 7 ist ein Querschnitt durch die zweite Ausführungsform des erfindungsgemäßen Ring-LMT 400 entlang der Schnittlinie B-B' aus der Figur 6 dargestellt. Gleiche Bezugszeichen aus der Figur 4 bezeichnen wiederum gleich Teile des Ring-LMT 400. In Figur 7 ist das Durchkontaktierungsloch 407, das die Vorder- und Rückseite des Ring-LMT 400 niederohmig miteinander verbindet, gut zu erkennen. Weiterhin ist das beispielsweise thermisch erzeugte Dielektrikum 601 erkennbar, das den ringförmig, das Durchkontaktierungsloch 407 umschließende "Sensorgebiet", bestehend aus den Kollektorgebieten 501, 502, dem Basisgebiet 504 und dem Emittergebiet 503 sowie dem Bereich 508, ringförmig umschließt.

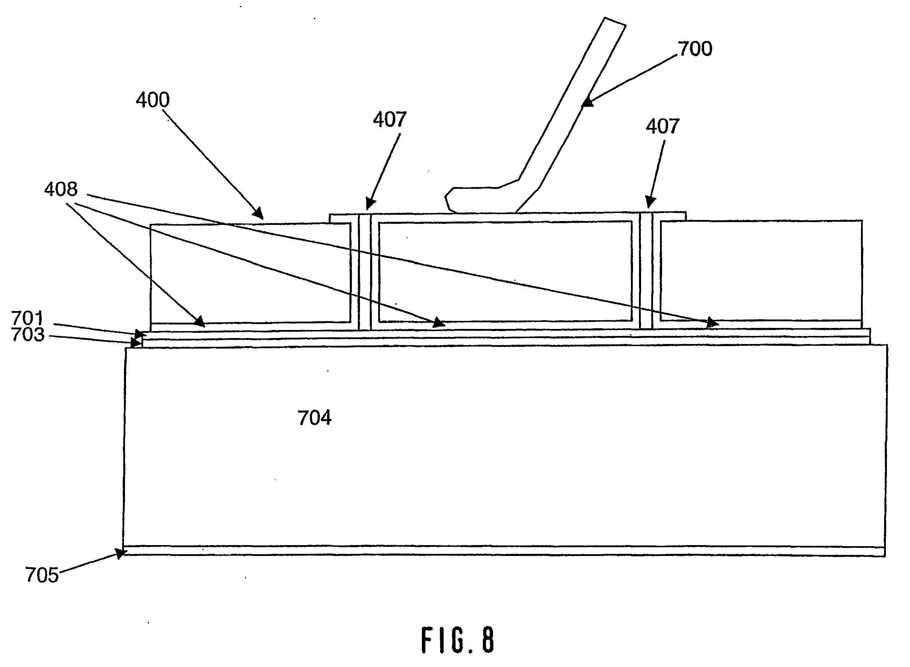

In Figur 8 ist ein Applikationsbeispiel für die zweite Ausführungsform des erfindungsgemäßen Ring-LMT 400 dargestellt. Der Ring-LMT wird hierzu mittels einer Kleberoder Lotschicht 701 Sourceseitig auf einem PowerMOS fixiert. Der PowerMOS umfasst in schematischer Darstellung einen Halbleiter 704, eine Drainmetallisierung 705 und eine Sourcemetallisierung 703. Der von der Oberseite des Ring-LMT 400 zugeführte, die Metallisierung 408 kontaktierende Sourcebond 700 führt den zu messenden Strom I_{M}, der vom PowerMOS gesteuert werden kann. Alternativ zum Bond 700 können selbstverständlich auch andere Kontaktierungsverfahren (z.B. Druckkontaktierung) für den Ring-LMT genutzt werden. Alternativ ist außerdem denkbar, dass der Ring-LMT 400 prinzipiell auch drainseitig am PowerMOS angebracht werden kann. Statt eines PowerMOS kann der Ring-LMT 400 auch auf einer metallisierten Leiterplatte oder Keramik, wie im Zusammenhang mit Figur 5 dargestellt, angebracht werden.

Prinzipiell sind bei den beschriebenen Ring-LMT 300, 400 alle p-Dotierungen bzw. Elektronenakzeptoren-Dotierungen durch entsprechende n-Dotierungen bzw. Elektronendonatoren-Dotierungen und umgekehrt ersetzbar; die zugehörigen Potentiale sind dann sinngemäß zu verändern. Erfindungsgemäß ist es insbesondere vorgesehen, mehrere Ring-LMT 300, 400 auf einem Chip 301 monolithisch zu integrieren. Auch eine monolithische Integration einer Verstärker- und Auswertungsschaltung ist denkbar.

Ein erfindungsgemäßer Strommesser umfasst insbesondere einen oder mehrere-erfindungsgemäße Ring-LMT 300, 400 mit einer Auswerteschaltung. Der Einsatz der erfindungsgemäßen Halbleiteranordnung ist insbesondere zur Benutzung im Kraftfahrzeug sinnvoll, weil sich durch den ringförmigen Schluß des Sensorortes 508, 504, 503 eine besonders gute Unempfindlichkeit gegen elektromagnetische Störfelder ergibt, die im Kraftfahrzeugbereich besonders häufig und intensiv auftreten und besonders schwerwiegende Konsequenzen nach sich ziehen können.

## Patentansprüche

1. Halbleiteranordnung zur Strommessung mit einer Ausnehmung (308), in der ein elektrischer Leiter (202) vorsehbar ist, wobei die Halbleiteranordnung Sensormittel aufweist derart, dass ein Magnetfeld durch die Sensormittel (300, 400) sensierbar ist, welches durch einen durch den vorsehbaren Leiter (202) fließenden Strom (I_{M}) bewirkt wird, wobei die Sensormittel vorgesehen sind, um das Magnetfeld an einem Gebiet (503, 504, 508) der Sensormittel zu sensieren, **dadurch gekennzeichnet, dass** das Gebiet (503, 504, 508) die Ausnehmung (308) vollständig umschließt und die Sensormittel einen lateralen Magnetotransistor (300, 400) umfassen und eine Kontur um die Ausnehmung bilden.

2. Halbleiteranordnung nach Anspruch 1, **dadurch gekennzeichnet, dass** die Halbleiteranordnung im Wesentlichen eben ist und die von den Sensormitteln gebildete Kontur überkreuzungsfrei ist.

3. Halbleiteranordnung nach Anspruch 2, **dadurch gekennzeichnet, dass** der laterale Magnetotransistor (300, 400) der Sensormittel ringförmig ist und ringförmige Anschlußgebiete (302, 303, 304, 305, 306) ausweist.

4. Halbleiteranordnung nach einem der vorhergehenden Ansprüche, **dadurch gekennzeichnet, dass** das der Aufbau des lateralen Magnetotransistors so ist, dass eine Emittermetallisierung (304) in der Mitte vorgesehen ist, unterhalb der sich ein vorzugsweise n-dotiertes Emittergebiet (503) befindet, das in ein vorzugsweise p-dotiertes Basisgebiet (504) eingebettet ist, auf dem sich symmetrisch zur Emittermetallisierung (304) die lateralen Basismetallisierungen (303, 305) befinden.

5. Halbleiteranordnung nach einem der vorhergehenden Ansprüche, **dadurch gekennzeichnet, dass** die Sensormittel ein dem Umlaufintegral der magnetischen Feldstärke und damit dem vom zu messenden Strom proportionales Signal liefern.

6. Halbleiteranordnung nach einem der vorhergehenden Ansprüche, **dadurch gekennzeichnet, dass** mehrere laterale Magnetotransistoren monolithisch integriert sind.

7. Halbleiteranordnung nach einem der vorhergehenden Ansprüche, **dadurch gekennzeichnet, dass** sie zur Strommessung in einem Kraftfahrzeug eingesetzt wird.

## Claims

1. Semiconductor arrangement for current measurement having a cut-out (308), in which an electrical conductor (202) can be provided, the semiconductor arrangement having sensor means in such a way that the sensor means (300, 400) can sense a magnetic field brought about by a current (I_{M}) flowing through the conductor (202) that can be provided, the sensor means being provided in order to sense the magnetic field at a region (503, 504, 508) of the sensor means, **characterized in that** the region (503, 504, 508) completely encloses the cut-out (308) and the sensor means comprise a lateral magnetotransistor (300, 400) and form a contour around the cut-out.

2. Semiconductor arrangement according to claim 1, **characterized in that** the semiconductor arrangement is essentially planar and the contour formed by the sensor means is crossover-free.

3. Semiconductor arrangement according to Claim 2, **characterized in that** the lateral magnetotransistor (300, 400) of the sensor means is annular and has annular connection regions (302, 303, 304, 305, 306).

4. Semiconductor arrangement according to one of the preceding claims, **characterized in that** the construction of the lateral magnetotransistor is such that an emitter metallization (304) is provided in the centre, below which is situated a preferably n-doped emitter region (503) embedded in a preferably p-doped base region (504), on which the lateral base metallizations (303, 305) are situated symmetrically with respect to the emitter metallization (304).

5. Semiconductor arrangement according to one of the preceding claims, **characterized in that** the sensor means supply a signal proportional to the circulatory integral of the magnetic field strength and thus to the current to be measured.

6. Semiconductor arrangement according to one of the preceding claims, **characterized in that** a plurality of lateral magnetotransistors are monolithically integrated.

7. Semiconductor arrangement according to one of the preceding claims, **characterized in that** it is used for current measurement in a motor vehicle.

## Revendications

1. Montage à semi-conducteur pour la mesure du courant comprenant une cavité (308) muni d'un conducteur électrique (202),
le montage semi-conducteur comportant des capteurs (300, 400) pour mesurer le champ magnétique engendré par le courant (I_{M}) passant dans le conducteur (202),
les capteurs étant prévus pour détecter le champ magnétique dans une zone (503, 504, 508) des capteurs,
**caractérisé en ce que**
la zone (503, 504, 508) entoure complètement la cavité (308), et les capteurs comprennent un magnétotransistor latéral (300, 400) et forment un contour autour de la cavité.

2. Montage à semi-conducteur selon la revendication 1,
**caractérisé en ce qu'**
il est essentiellement plan et le contour formé par les capteurs ne présente pas de croisement.

3. Montage à semi-conducteur selon la revendication 2,
**caractérisé en ce que**
le magnétotransistor latéral (300, 400) des capteurs est de forme annulaire et comporte une zone de branchement annulaire (302, 303, 304, 305, 306).

4. Montage à semi-conducteur selon l'une des revendications précédentes,
**caractérisé en ce que**
le montage du magnétotransistor latéral comporte une métallisation d'émetteur (304) en son milieu en dessous de laquelle se trouve une zone d'émetteur (503), de préférence à dopage n, noyée dans une zone de base (504), de préférence à dopage p et la métallisation de base, latérale (303, 305) est symétrique par rapport à la métallisation d'émetteur (304).

5. Montage à semi-conducteur selon l'une des revendications précédentes,
**caractérisé en ce que**
les capteurs fournissent un signal proportionnel à l'intégrale circulaire de l'intensité du champ magnétique et ainsi un signal proportionnel au courant à mesurer.

6. Montage à semi-conducteur selon l'une des revendications précédentes,
**caractérisé par**
une intégration monolithique de plusieurs magnétotransistors latéraux.

7. Montage à semi-conducteur selon l'une des revendications précédentes,
**caractérisé en ce qu'**
il est appliqué à la mesure du courant dans un véhicule automobile.
